Europäisches Patentamt

European Patent Office

Office européen des brevets

(11) Publication number: **0 326 741**
**A2**

(12) **EUROPEAN PATENT APPLICATION**

(21) Application number: 88309855.0

(51) Int. Cl.⁴: **G11B 5/39**

(22) Date of filing: 20.10.88

(30) Priority: 05.02.88 US 152783

(43) Date of publication of application:
09.08.89 Bulletin 89/32

(84) Designated Contracting States:
DE FR GB

(71) Applicant: MAGNETIC PERIPHERALS INC.
8100-34th Avenue South
Minneapolis Minnesota 55440(US)

(72) Inventor: Mowry, Gregory Stephen
13905 James Avenue South
Burnsville Minnesota 55337(US)

(74) Representative: Caro, William Egerton et al
J. MILLER & CO. Lincoln House 296-302 High
Holborn
London WC1V 7JH(GB)

(54) **Unbiased single magneto-resistive element ganged read head sensor.**

(57) An unbiased single magneto-resistive element ganged read head sensor comprises an elongate magneto-resistive sensor element (10), sense current contacts (20,22,24) contacting the sense element and defining a plurality of sense regions (12,14) between the contacts. The regions of the sense element in the area of the contact is maintained with substantially the same coercivity as that of the sense regions (12,14). There is no transverse biasing.

Fig. 1

EP 0 326 741 A2

## UNBIASED SINGLE MAGNETO-RESISTIVE ELEMENT GANGED READ HEAD SENSOR

This invention relates to unbiased single magneto-resistive element ganged read head sensors.

As the performance of computer systems continues to increase, so does the demand for storage capacity and data transfer rate of computer peripherals. In Winchester disk drives, one proposal for accomplishing these objectives is to provide read heads which read data in parallel, i.e. read recorded information on two or more tracks simultaneously. Such heads are known as ganged read head sensors. One example is disclosed in US-A-4,356,523. US-A-4,356,523 describes the typical approach for magneto-resistive ganged head sensors. The magneto-resistive head sensor comprises a separate element (here a coupled set of vertical oriented elements) mounted in a larger apparatus.

According to one aspect of the present invention there is provided an unbiased single magneto-resistive element ganged read head sensor characterised by comprising: a elongate magneto-resistive sensor element; a plurality of sense current contacts contacting the sensor element and defining a plurality of sense regions between the contacts; the regions of the sensor element in the area of the contacts being maintained with substantially the same coercivity as that of the sense regions; and no transverse biasing means.

In one embodiment, the sensor element has a lower edge, the easy axis of magnetisation to said sensor element is parallel with said lower edge and the contacts have parallel facing sides each of which is perpendicular to the lower edge.

According to another aspect of the present invention, there is provided apparatus comprising: an unbiased ganged, magneto-resistive sensor characterised by comprising: a plurality of sense regions formed from a single magneto-resistive element having a magnetisation vector M aligned parallel to the easy axis in the absence of external fields; means for providing a sense current in each of the sense regions, each sense current having a vector I substantially parallel with said easy axis magnetisation vector M; a magnetic recording medium mounted adjacent to said sensor such that relative motion between them can occur, the magnetic medium having a plurality of magnetisation transitions recorded thereon in a parallel track arrangement providing magnetic flux pulses to respective of said sense regions as the transitions of respective tracks pass the sensor, the peak flux amplitude of the pulses being sufficient to rotate a respective sense region's magnetisation vector M away from the sense current vector I so that the angle between them is in the range of $40°$ to $50°$,

whereby the sensor response in the region of the pulse peak is approximately a linear function of magnetic flux of the transition; and a plurality of regions of anti-ferro-magnetic material contacting the magneto-resistive element between sense regions to provide increased cross talk isolation between sense regions.

The invention is illustrated, merely by way of example, in the accompanying drawings, in which:-

Figure 1 is a plan view of part of one embodiment of an unbiased single magneto-resistive element ganged read head sensor according to the present invention with contacts, a brief schematic diagram of a sense circuit, and a cross section of a recording media;

Figure 2 is a plan view of a second embodiment of an unbiased single magneto-resistive element ganged read head sensor according to the present invention, showing exchange-coupled antiferro-magnetic material; and

Figure 3 is a cross section taken on the line 3 - 3 of Figure 2.

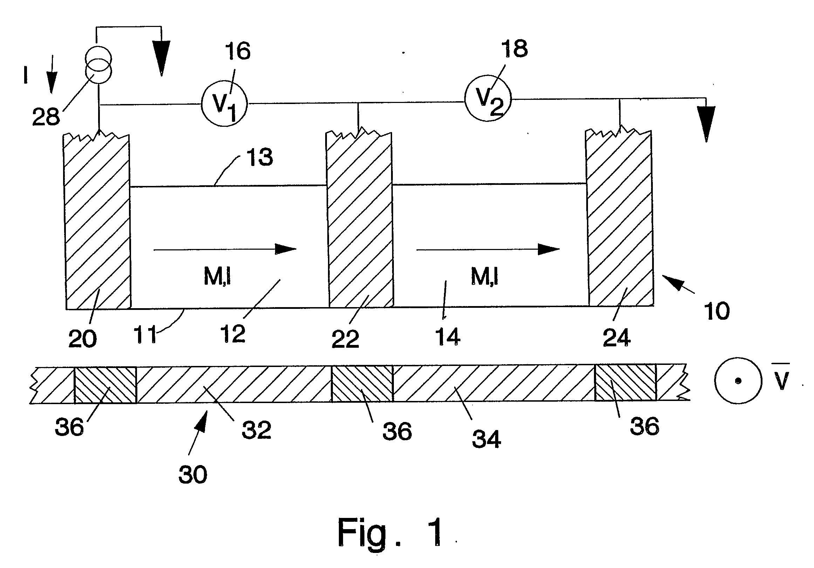

Figure 1 illustrates part of an unbiased single magneto-resistive element ganged read head sensor according to the present invention having an elongate magneto-resistive sensor element 10. Whilst the head sensor is shown with only two sensor regions 12,14 for sensing two data tracks 32,34 of a flat recording media 30, the concept of the present invention can be extended to any number of sense regions and tracks. Further, while the present invention is described in relation to data tracks having guard bands 36, the present invention is also useful for reading servo tracks (not shown) by proper electronic switching.

For example, if proper servo track information is written in tracks 32,34, then by subtracting a signal output $V_1$ from a signal output $V_2$, a linear off-track error voltage versus position can be generated. The resulting error voltage provides the necessary input for track following circuitry to minimise track misregistration.

In Figure 1, the sensor element 10 is conventionally composed of 80:20 nickel-iron alloy. The sensor element 10 has an upper edge 13 and a lower edge 11, the edges being parallel to each other and, when mounted in a read head (the other elements of which are not shown in Figure 1 for the purpose of clarity), the edges are also parallel to the recording media 30. In some devices, such as Winchester disk drives, the head sensor will fly a short distance above the recording media. In other devices, such as tape drives, the head sensor will be mechanically fixed in relation to the recording media. The easy axis of magnetisation of the sensor element 10 is directed parallel to these upper and lower edges 11,13, as indicated by a magnetic vector M.

The sensor element 10 is divided into the two sense regions 12,14 by contacts 20,22,24 connected to the sensor element on one side thereof. In those portions of the contacts connected to the sensor element 10, the facing sides of the contacts are parallel to each other and perpendicular to the lower edge 11 of the sensor element.

When properly aligned above the recording media 30 by conventional mechanical or servo means (not shown) the longitudinal dimensions of each sense region 12,14 between facing contacts 20,22 and 22,24 is nominally the width of one of the tracks 32,34 in which data has been magnetically pre-recorded. The tracks are conventionally separated by the guard bands 36. The width of contacts 20,22,24 is nominally that of the guard bands 36.

In operation, the recording media 30 is in motion relative to the sensor element in the direction shown by vector V. Data recorded along the track in the form of magnetic flux transitions passes serially under a sense region and causes a localised change in resistivity which can be electronically sensed and converted into data.

A current source is connected to the conductor 20 and a current drain is connected to the conductor 24. So connected, current I flows through the sensor element 10 in the direction indicated by vector I. A first voltage sensor 16 is connected between the contact 20 and the contact 22, and a second voltage sensor 18 is connected between the contact 22 and the contact 24. The voltage drop across the sense region 12 is sensed by the voltage sensor 16 and the voltage drop across the other sense region 14 is sensed by the voltage sensor 18. It will be appreciated that the voltage drop across the respective sense regions will change according to the magnetic fields in the sense regions originating from the recording media 30 (and tracks 32, 34 when the sensor element is properly aligned above them).

Because the facing sides of the contacts 20,22,24 are parallel, no canted or transverse current biasing is present. Further, no external biasing fields are provided to cant the magnetic vector M. Moreover, the regions of the sensor element in the area of the contacts 20,22,24 is maintained with substantially the same coercivity as that of the sense regions. This arrangement results in the output of the voltage sensors 16,18 being a non-linear function of the input magnetic fields from the recording media 30. However, as disclosed in EP-A-0,279,535, in the context of data recording where the location of a data magnetic transition is important rather than its strength or polarity, a non-linear sensor operation is actually preferred. The peak flux strength of a transistion from the recording media 30 should be sufficient to rotate the magnetisation vector M so that the response of the sensor to the peak flux is a linear replication of the flux. This occurs when the peak flux rotates the vector M approximately 40° to 50°. Moreover, the provision of no external magnetic biasing fields permits the operation of magnetic relaxation of the sensor element. This inherently reduces the transmission of the effects of a localised magnetic perturbation through the sensor element. As a result cross talk from adjacent tracks is reduced. This permits tracks to be recorded far more closely together than would otherwise be expected.

In the embodiment of the invention shown in Figure 1, sufficient signal-to-noise ratio exists with conventional low noise thin film recording media recorded conventionally with data yielding a 300 gauss (0.03 T) peak magnetic field at the surface of the recording media with the sensor element spaced (i.e. flying or mechanically fixed) from the recording media 30 a distance of 0.05 - 0.25 μm such that the distance between the facing surfaces of the contacts 20,22,24 can be in the range of 2 to 4 μm and the width of the contacts 20,22,24 being in the range 1 to 2 μm, with the tracks 32,34 and guard bands being of corresponding dimensions, such that around 2400 tracks per centimetre (6000 tracks per inch) can be read.

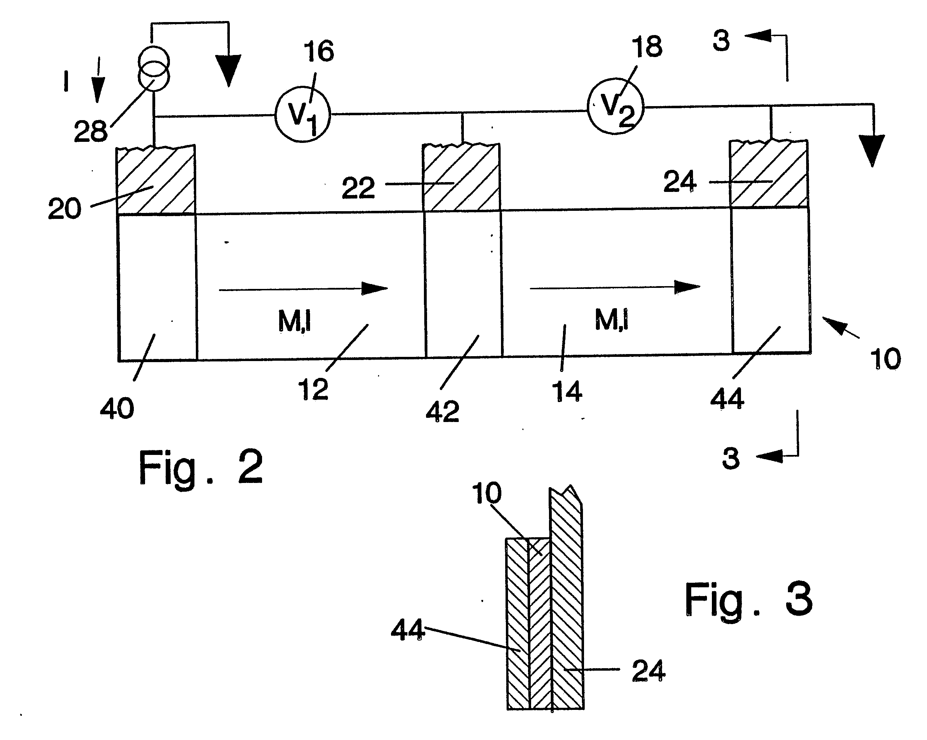

Figure 2 illustrates a second embodiment of an unbiased single magneto-resistive element ganged read head sensor according to the present invention in which cross talk is even further reduced, thereby permitting even greater track density. This embodiment is essentially the same as that of Figure 1, with the addition of anti-ferro-magnetic material 40,42,44 exchange-coupled to the sensor element 10 in the region of the contacts 20,22,24, but on the opposite side of the sensor element 10 therefrom. Deposition of the anti-ferro-magnetic material on the opposite side of the contacts is not necessary if the anti-ferro-magnetic material is a conductor. Thus, in Figure 2, the anti-ferro-magnetic material 40,42,44, which is conventionally 50:50 iron-manganese, is exchange-coupled to cover substantially the same area of the sensor element as the corresponding contacts 20,22,24, but on the opposite side of the sensor element as shown in Figure 3.

This exchange-coupled anti-ferro-magnetic material "freezes" the magnetic orientation of the magneto-resistive material of the sensor element to which it is coupled. This effectively prevents magnetic perturbation induced in one sense region 12,14 from being transmitted through the sensor element to the other sense region 14,12. Thus cross talk is reduced to only that caused by the direct influence of one track, e.g. the track 32, on the adjacent sense region, e.g. the sense region 14.

## Claims

1. An unbiased single magneto-resistive element ganged read head sensor characterised by comprising: a elongate magneto-resistive sensor element (10); a plurality of sense current contacts (20,22,24) contacting the sensor element and defining a plurality of sense regions (12,14) between the contacts; the regions of the sensor element in the area of the contacts being maintained with substantially the same coercivity as that of the sense regions (12,14); and no transverse biasing means.

2. A read head sensor as claimed in claim 1 characterised in that the sensor element (10) has a lower edge (11), the easy axis of magnetisation to said sensor element is parallel with said lower edge (11) and the contacts (20,22,24) have parallel facing sides each of which is perpendicular to the lower edge (11).

3. Apparatus comprising: an unbiased ganged, magneto-resistive sensor characterised by comprising: a plurality of sense regions (12,14) formed from a single magneto-resistive element (10) having a magnetisation vector M aligned parallel to the easy axis in the absence of external fields; means (20,22,24) for providing a sense current in each of the sense regions, each sense current having a vector I substantially parallel with said easy axis magnetisation vector M; a magnetic recording medium mounted adjacent to said sensor such that relative motion between them can occur, the magnetic medium having a plurality of magnetisation transitions recorded thereon in a parallel track arrangement providing magnetic flux pulses to respective of said sense regions (12,14) as the transitions of respective tracks pass the sensor, the peak flux amplitude of the pulses being sufficient to rotate a respective sense region's magnetisation vector M away from the sense current vector I so that the angle between them is in the range of $40^\circ$ to $50^\circ$, whereby the sensor response in the region of the pulse peak is approximately a linear function of magnetic flux of the transition; and a plurality of regions (40,42,44) of anti-ferro-magnetic material contacting the magneto-resistive element between sense regions to provide increased cross talk isolation between sense regions.

Fig. 1

EP 0 326 741 A2

Fig. 2

Fig. 3

EP 0 326 741 A2